# EUROPEAN PATENT APPLICATION

(11) **EP 4 598 281 A1**
(43) Date of publication of application: **06.08.2025**
(21) Application number: 23872185.6
(22) Date of filing: 22.09.2023
(51) Int. Cl.: H05K 1/02, H01P 3/08, H01P 3/12, H01P 5/107

(54) **WIRING BOARD, ELECTRONIC COMPONENT STORAGE PACKAGE, AND ELECTRONIC DEVICE**

(30) Priority: 30.09.2022 JP 2022158012
(71) Applicant: Kyocera Corporation, Kyoto-shi, Kyoto 612-8501 (JP)
(72) Inventor: SHIRASAKI, Takayuki, Kyoto-shi, Kyoto 612-8501 (JP)
(74) Representative: Viering, Jentschura & Partner mbB Patent- und Rechtsanwälte
(86) International application number: PCT/JP2023/034536
(87) International publication number: WO 2024/070959

(57) **Abstract**

A wiring board includes a base body, a signal line located at the base body, and a waveguide of a waveguide-type located at the base body. The signal line includes a first end part that is one end of the signal line in a signal transmission direction. The waveguide includes a second end part that is one end of the waveguide in the signal transmission direction, a center part in the signal transmission direction, and an intermediate part on a side of the second end part closer to the center part. The first end part and the second end part are coupled to one another. A width of the waveguide at the second end part is wider than a width of the waveguide at the intermediate part.

## Description

### TECHNICAL FIELD

The present disclosure relates to a wiring board, an electronic component storage package, and an electronic device.

### BACKGROUND OF INVENTION

Patent Literature 1 describes a signal transmission line with a microstrip line and a waveguide-type waveguide coupled to one another in a wiring board.

### CITATION LIST

### PATENT LITERATURE

Patent Literature 1: Japanese Unexamined Patent Application Publication No. 2004-153368

### SUMMARY

### PROBLEM TO BE SOLVED

A transmission line with a signal line and a waveguide-type waveguide coupled to one another may be effective for transmitting a radio-frequency signal. In recent years, a further increase in a frequency of a transmission signal has been demanded.

The present disclosure provides a wiring board, an electronic component storage package, and an electronic device including a transmission line with a signal line and a waveguide-type waveguide coupled to one another and adaptable for a higher frequency.

### SOLUTION TO PROBLEM

In the present disclosure, a wiring board includes a base body, a signal line, and a waveguide of a waveguide-type. The signal line is located at the base body. The waveguide-type waveguide is located at the base body. The signal line includes a first end part that is one end of the signal line in a signal transmission direction. The waveguide includes a second end part that is one end of the waveguide in the signal transmission direction, a center part in the signal transmission direction, and an intermediate part on a side of the second end part closer to the center part. The first end part and the second end part are coupled to one another. A width Wa of the waveguide at the second end part is wider than a width Wb of the waveguide at the intermediate part.

In the present disclosure, an electronic component storage package includes the wiring board describe above.

In the present disclosure, an electronic device includes the electronic component storage package described above and an electronic component. The electronic component is stored in the electronic component storage package.

### ADVANTAGEOUS EFFECT

According to the present disclosure, a radio-frequency signal is transmittable via a transmission line with a signal line and a waveguide-type waveguide coupled to one another, and the transmission line is adaptable for a higher frequency.

### BRIEF DESCRIPTION OF THE DRAWINGS

FIG. 1A is a plan view illustrating a wiring board according to an embodiment of the present disclosure.
FIG. 1B is a side view illustrating a wiring board according to an embodiment of the present disclosure.
FIG. 1C is a back view illustrating a wiring board according to an embodiment of the present disclosure.
FIG. 1D is a front view illustrating a wiring board according to an embodiment of the present disclosure.
FIG. 2A is a perspective view illustrating a wiring board of Reference Example 1.
FIG. 2B is an enlarged view of a part C1, illustrating the wiring board of Reference Example 1.
FIG. 3A is a graph showing reflection characteristics of Reference Examples 1a to 1d with different pullback lengths.
FIG. 3B is a graph showing transmission characteristics of Reference Examples 1a to 1d with different pullback lengths.
FIG. 4A is a perspective view illustrating a wiring board according to Embodiment 1 of the present disclosure.
FIG. 4B is a perspective view illustrating the wiring board according to Embodiment 1 of the present disclosure.
FIG. 5A is a graph showing reflection characteristics of Embodiments 1a to 1e and Reference Example 1a with different ratios "Wa/Wb".
FIG. 5B is a graph showing transmission characteristics of Embodiments 1a to 1e and Reference Example 1a with different ratios "Wa/Wb".
FIG. 6A is a graph showing reflection characteristics of Embodiments 1f to 1j and Reference Example 1a with different wide-section lengths.
FIG. 6B is a graph showing transmission characteristics of Embodiments 1f to 1j and Reference Example 1a with different wide-section lengths.
FIG. 7 is a perspective view illustrating a wiring board according to Embodiment 2 of the present disclosure.
FIG. 8A is a graph showing reflection characteristics of Embodiments 2a to 2e and Reference Example 1a with different wide-section lengths.
FIG. 8B is a graph showing transmission characteristics of Embodiments 2a to 2e and Reference Example 1a with different wide-section lengths.
FIG. 9A is a plan view illustrating a part of a wiring board of Embodiment 3a of the present disclosure.
FIG. 9B is a plan view illustrating a part of a wiring board of Embodiment 3b of the present disclosure.
FIG. 9C is a plan view illustrating a part of a wiring board of Embodiment 3c of the present disclosure.
FIG. 10A is a graph showing reflection characteristics of the wiring boards of Embodiments 3a to 3c and a wiring board of Reference Example 1a.
FIG. 10B is a graph showing transmission characteristics of the wiring boards of Embodiments 3a to 3c and the wiring board of Reference Example 1a.
FIG. 11A is a perspective view illustrating Embodiment 4a of the present disclosure.
FIG. 11B is a perspective view illustrating Embodiment 4b of the present disclosure.
FIG. 11C is a perspective view illustrating Reference Example 2.
FIG. 12A is a graph showing reflection characteristics of wiring boards of Embodiments 4a and 4b and a wiring board of Reference Example 2.
FIG. 12B is a graph showing transmission characteristics of the wiring boards of Embodiments 4a and 4b and the wiring board of Reference Example 2.
FIG. 13A is a perspective view illustrating a wiring board of Embodiment 5 of the present disclosure.
FIG. 13B is a perspective view illustrating a wiring board of Reference Example 3.
FIG. 14A is a graph showing reflection characteristics of wiring boards of Embodiments 5a and 5b and the wiring board of Reference Example 3.
FIG. 14B is a graph showing transmission characteristics of the wiring boards of Embodiments 5a and 5b and the wiring board of Reference Example 3.
FIG. 15 is a perspective view illustrating a wiring board of Embodiment 6 of the present disclosure.
FIG. 16A is a graph showing reflection characteristics of the wiring boards of Embodiments 6 and 1b and Reference Example 1a.
FIG. 16B is a graph showing transmission characteristics of the wiring boards of Embodiments 6 and 1b and Reference Example 1a.
FIG. 17 is a perspective view illustrating a wiring board of Embodiment 7 of the present disclosure.
FIG. 18A is a side view of the wiring board of Embodiments 1 to 7.
FIG. 18B is a sectional view of the wiring board of Embodiments 1 to 7 taken along line B-B.
FIG. 18C is a side view of a wiring board of Embodiment 8 of the present disclosure.
FIG. 18D is a sectional view of the wiring board of Embodiment 8 taken along line D-D.
FIG. 19A is a side view of a wiring board of Embodiment 9 of the present disclosure.
FIG. 19B is a sectional view of the wiring board of Embodiment 9 taken along line B-B.
FIG. 19C is a side view of a wiring board of Embodiment 10 of the present disclosure.
FIG. 19D is a sectional view of the wiring board of Embodiment 10 taken along line D-D.
FIG. 20 is an exploded perspective view illustrating an electronic component storage package and an electronic device according to an embodiment of the present disclosure.
FIG. 21 is a plan view illustrating an electronic component storage package and an electronic device according to an embodiment of the present disclosure.

### DESCRIPTION OF EMBODIMENTS

Hereinafter, each embodiment of the present disclosure is described in detail with reference to the drawings.

### (Embodiment 1)

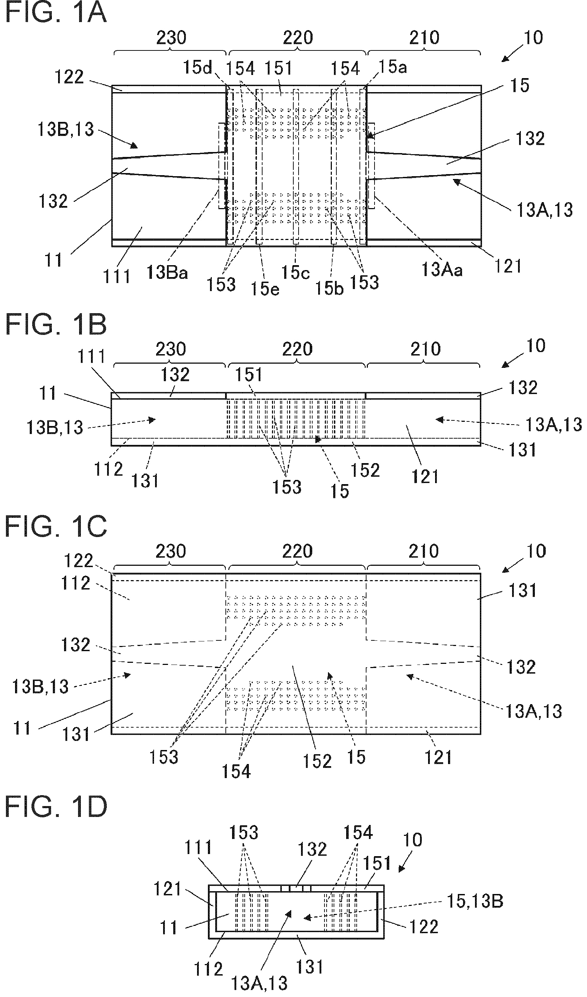

FIGs. 1A to 1D are views illustrating a wiring board according to Embodiment 1 of the present disclosure, where FIG. 1A is a plan view, FIG. 1B is a side view, FIG. 1C is a back view, and FIG. 1D is a front view. FIGs. 1A to 1D illustrate a thickness of a film-like conductor in an exaggerated manner.

As illustrated in FIGs. 1A to 1D, according to Embodiment 1, a wiring board 10 includes a base body 11, a signal line 13 located at the base body 11, and a waveguide 15 of a waveguide-type located at the base body 11. The signal line 13 may include a first signal line 13A and a second signal line 13B. The first signal line 13A may be located on one side and the second signal line 13B may be located on the other side while sandwiching the waveguide 15 therebetween.

The base body 11 may have a plate-like shape and include a first main surface 111 and a second main surface 112 opposite to the first main surface 111. The main surface may mean a widest surface of a plate and a surface opposed to this widest surface. The base body 11 may be a dielectric. A material for the base body 11 may adopt ceramics, such as an aluminum oxide-based sintered body, a glass-ceramic sintered body, a mullite-based sintered body, and an aluminum nitride-based sintered body, or resin.

In the following description, a signal transmission direction is a front-rear direction, a direction in which the first main surface 111 and the second main surface 112 are located is an up-down direction, and a direction orthogonal to the front-rear direction and the up-down direction is a left-right direction. These directions may be different from directions in use of the wiring board 10.

The wiring board 10 may transmit a signal from a front part to a rear part, from the rear part to the front part, or both from the front part to the rear part and from the rear part to the front part of the wiring board 10. The wiring board 10 may include a first section 210 where the first signal line 13A at one side is located, a second section 220 where the waveguide 15 is located, and a third section 230 where the second signal line 13B at the other side is located. The first section 210, the second section 220, and the third section 230 may be arranged in this order in the front-rear direction (see FIGs. 1A to 1C). A rear-end part 13Aa (corresponding to a "first end part") of the first signal line 13A may be coupled to a front-end part 15a (corresponding to a "second end part") of the waveguide 15 (see FIG. 1A). A rear-end part 15d (corresponding to the "second end part") of the waveguide 15 may be coupled to a front-end part 13Ba (corresponding to the "first end part") of the second signal line 13B (see FIG. 1A). Being coupled may mean being continued in a signal-transmittable manner.

The first signal line 13A may be a microstrip line. The first signal line 13A may include a film-like conductor 131 located on the second main surface 112 of the base body 11, and a belt-like conductor 132 located on the first main surface 111 of the base body 11. The film-like conductor 131 of the first signal line 13A is a ground-potential surface and may be located on the entire second main surface 112 in the first section 210. The belt-like conductor 132 of the first signal line 13A extends in the front-rear direction from a front end to a rear end of the first section 210. The belt-like conductor 132 of the first signal line 13A may have a shape with a gradually increasing width (that is, a length in the left-right direction) from the front end to the rear end. The first signal line 13A may have a left-right symmetrical shape. The first signal line 13A may transmit a transmission signal in a TEM (transverse electromagnetic) mode.

The waveguide 15 may include film-like conductors 151 and 152 and wall conductors 153 and 154. The film-like conductors 151 and 152 partition a signal transmission line in the up-down direction, and the wall conductors 153 and 154 partition the signal transmission line in the left-right direction. The film-like conductors 151 and 152 may be located on the first main surface 111 and the second main surface 112, respectively. Each of the wall conductors 153 and 154 may include an upper-end part and a lower-end part thereof coupled to the film-like conductors 151 and 152, respectively. Each of the wall conductors 153 and 154 may include multiple via conductors arranged with a gap therebetween in the front-rear direction. Even when each of the wall conductors 153 and 154 includes a gap, the gap with a narrow width relative to a wavelength of a transmission signal causes small leakage of the transmission signal, and the wall conductors 153 and 154 function as a partition that confines the transmission signal in the transmission line. In the second section 220, the film-like conductors 151 and 152 may be located on the entire first main surface 111 and the entire second main surface 112, respectively. The film-like conductors 151 and 152 and the wall conductors 153 and 154 may be grounded. The waveguide 15 may have a left-right symmetrical shape. The waveguide 15 may have a front-rear symmetrical shape. The waveguide 15 may transmit a transmission signal in a mode different from the TEM mode.

The belt-like conductor 132 of the first signal line 13A and the film-like conductor 151 of the waveguide 15 may physically be coupled to one another at a coupling part between the first signal line 13A and the waveguide 15. In the same and/or similar manner, the film-like conductor 131 of the first signal line 13A and the film-like conductor 152 of the waveguide 15 may physically be coupled to one another. The first signal line 13A may be coupled to the waveguide 15 at a middle in the left-right direction.

The second signal line 13B may include a configuration the same as and/or similar to that of the first signal line 13A except for that the second signal line 13B is coupled to the rear-end part 15d of the waveguide 15, which is an opposite direction in the front-rear direction from that for the first signal line 13A. Specifically, the belt-like conductor 132 of the second signal line 13B may extend in the front-rear direction from a rear end to a front end of the third section 230. The belt-like conductor 132 of the second signal line 13B may have a shape with a gradually increasing width (that is, a length in the left-right direction) from the rear end to the front end.

Film-like conductors 121 and 122 may be located on respective ones of left and right side surfaces of the base body 11 (see FIG. 1D). The film-like conductors 121 and 122 may be located on the entire side surfaces. The film-like conductors 121 and 122 may be grounded. The film-like conductor 131 of the first signal line 13A, the film-like conductor 131 of the second signal line 13B, and the film-like conductor 152 of the waveguide 15 may cover the entire second main surface 112 of the base body 11.

With the configuration as described above, the wiring board 10 causes a radio-frequency signal to be transmitted through the first signal line 13A, the waveguide 15, and the second signal line 13B in this order once the radio-frequency signal is input from the front part of the wiring board 10, and then to be output from the rear part of the wiring board 10. A radio-frequency signal is transmitted through the first signal line 13A and the second signal line 13B in the TEM mode whereas a radio-frequency signal is transmitted through the waveguide 15 in a mode different from the TEM mode.

### <Detailed Configuration and Characteristic>

Detailed configurations and characteristics of the wiring board 10 are described. The characteristics include reflection characteristics (that is, S11 parameter) and transmission characteristics (that is, S21 parameter) and are obtained through simulations. In the simulations, a thickness (that is, a dimension in the up-down direction) of the base body 11 is 0.2 mm, a relative permittivity of the base body 11 is 9.5, and a frequency band of a transmission signal is from 57 GHz to 71 GHz, and parameters including a width of the belt-like conductor 132 and a width of the waveguide 15 (for example, a reference width of 1 mm, which will be described later) are set in such a manner as to match impedance. A center frequency of a transmission signal is 64 GHz.

### (Reference Example 1)

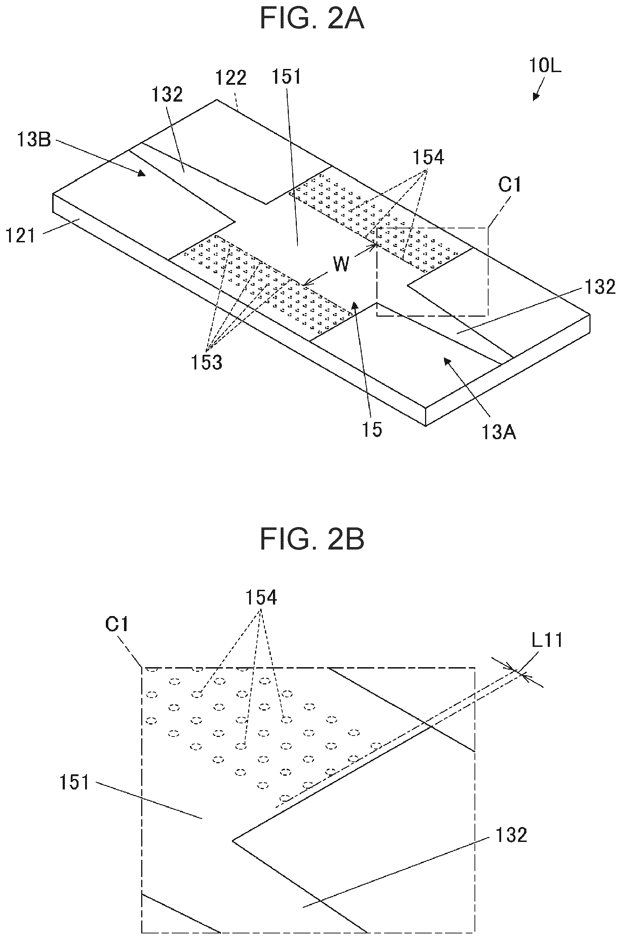

FIG. 2A is a perspective view illustrating a wiring board of Reference Example 1. FIG. 2B is an enlarged view of a part C1 of Reference Example 1. A wiring board 10L of Reference Example 1 is the same as and/or similar to the wiring board 10 described above except for that the wiring board 10L includes a different configuration related a width W of the waveguide 15.

In the wiring board 10L of Reference Example 1, the waveguide 15 has the same width W from the front end to the rear end of the waveguide 15 at the reference width (for example, 1 mm). The width W of the waveguide 15 corresponds to a distance in the left-right direction between the left wall conductor 153 and the right wall conductor 154 and may be referred to as a width of a signal transmission line.

When each of the wall conductors 153 and 154 includes multiple conductors arranged with a gap therebetween, the width W may be determined while assuming that the multiple conductors are connected together as described below. That is, among the plurality of wall conductors (for example, a plurality of via conductors) 153 at the left, a space between each pair of wall conductors 153 may be assumed to be filled with a surface conductor with a minimum area. Such a pair of wall conductors 153 are adjacent to one another at a distance from 1/4 or less to 1/8 or less of an effective wavelength of a transmission signal (that is, an effective wavelength at a center frequency). In the same and/or similar manner, among the plurality of wall conductors 154 at the right, a space between a pair of wall conductors 154 may be assumed to be filled with a surface conductor with a minimum area. Such a pair of wall conductors 154 are adjacent to one another at a distance from 1/4 or less to 1/8 or less of an effective wavelength of a transmission signal (that is, an effective wavelength at a center frequency). The distance in the left-right direction from the left wall conductor 153 to the right wall conductor 154 each including the space filled with the surface conductor as described above may be assumed to be the width W.

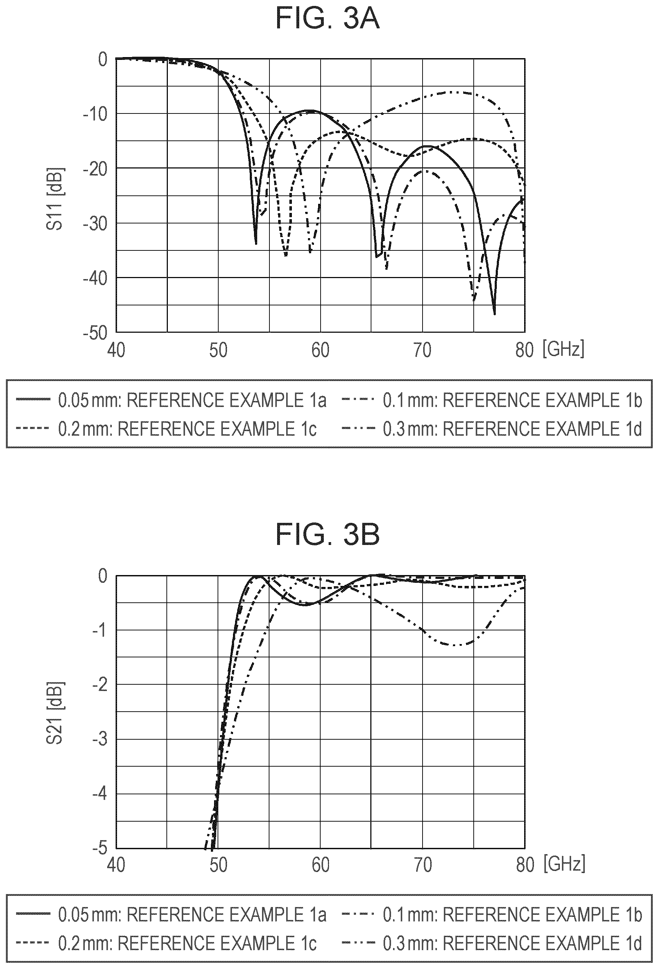

FIGs. 3A and 3B are graphs showing reflection characteristics and transmission characteristics, respectively, of Reference Examples 1a to 1d with different pullback lengths. The wiring board 10L of Reference Example 1 includes a plurality of configurations in which only a pullback length L11 varies, and these configurations are referred to as Reference Examples 1a to 1d. As illustrated in FIG. 2B, the pullback length L11 corresponds to a length from a front end of the film-like conductor 151 to a front end of each of the wall conductors 153 and 154. The same and/or similar holds for the rear-end portion. The pullback lengths L11 in Reference Examples 1a to 4 are "0.05 mm" (= 0.03 λ), "0.1 mm" (= 0.07 λ), "0.2 mm" (= 0.14 λ), and "0.3 mm" (= 0.2 λ), respectively. The "λ" is an effective wavelength at a center frequency of a transmission signal.

FIGs. 3A and 3B illustrate that in the configuration with the pullback length L11 of 0.14 λ or less, favorable characteristics are achievable.

In simulations of Embodiments 1a to 1j, 2a to 2e, and 3a to 3c described later, the pullback length L11 is the same at "0.05 mm". In some of characteristic graphs showing simulation results, the characteristics of Reference Example 1a having the same pullback length L11 are shown as a comparison target.

### (Embodiment 1)

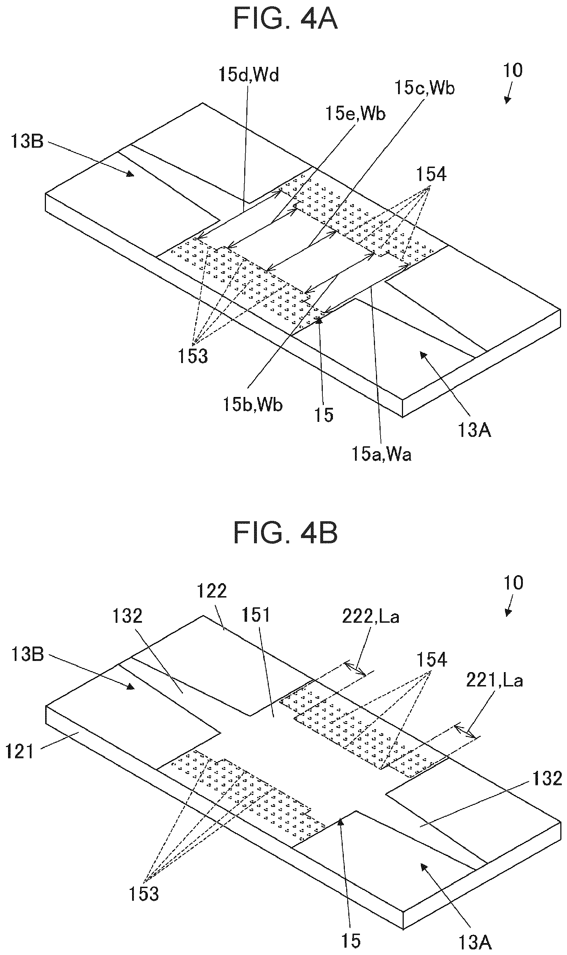

FIGs. 4A and 4B are perspective views illustrating the wiring board 10 according to Embodiment 1 of the present disclosure. FIGs. 4A and 4B illustrate the same wiring board 10.

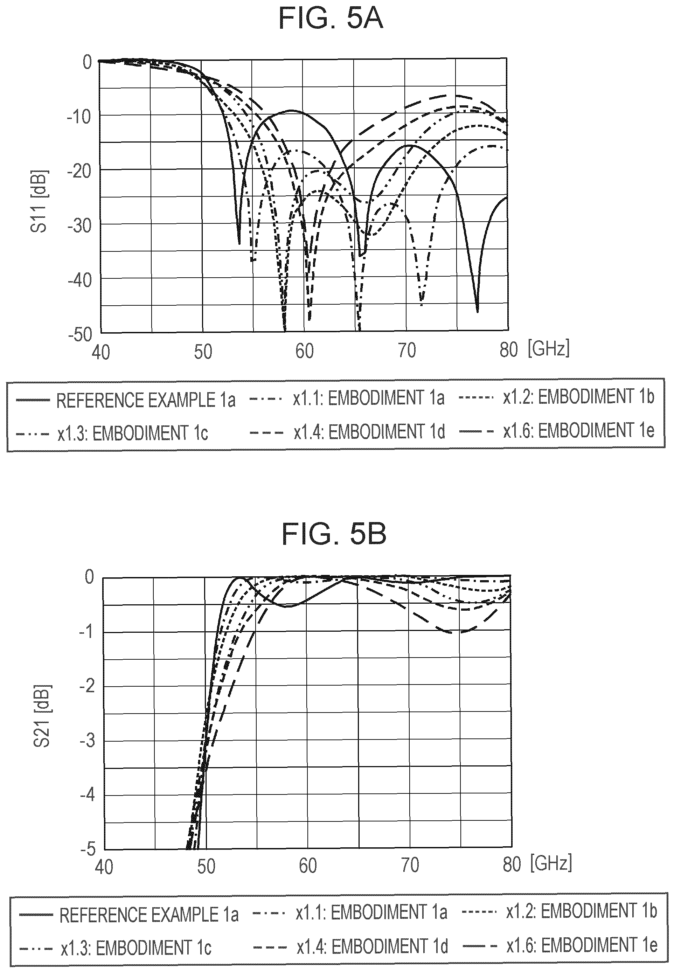

The waveguide 15 includes the front-end part 15a and an intermediate part 15b on a side of the front-end part 15a closer to a center part 15c in the front-rear direction (see FIGs. 4A and 1A). A width Wa of the front-end part 15a may be wider than a width Wb of the intermediate part 15b (see FIG. 4A). As shown in simulation results described later (see FIGs. 5A and 5B), with this configuration, favorable characteristics are achievable. The width Wb of the intermediate part 15b may be the reference width (for example, 1 mm) described above. In Embodiment 1, a width Wd of the rear-end part 15d and a width Wb of the rear-side intermediate part 15e of the waveguide 15 may also be same as and/or similar to the width Wa of the front-end part 15a and the width Wb of the intermediate part 15b, respectively. That is, the width Wd of the rear-end part 15d may be wider than the width Wb of the rear-side intermediate part 15e, and with this configuration, favorable characteristics are achievable. The width Wd of the rear-end part 15d is the same as and/or similar to the width Wa of the front-end part 15a, thus being interchangeable with the width Wa.

A ratio "Wa/Wb" of the width Wa of the front-end part 15a to the width Wb of the intermediate part 15b may be 1 < Wa/Wb ≤ 1.4. As shown in the simulation results described later (see FIGs. 5A and 5B), with this configuration, more favorable characteristics are achievable. In the same and/or similar manner, a ratio "Wd/Wb" of the width Wd of the rear-end part 15d to the width Wb of the intermediate part 15e may be 1 < Wd/Wb ≤ 1.4. With this configuration, more favorable characteristics are achievable.

A width of the waveguide 15 may be wider across a certain section extending rearward from the front-end part 15a than the width Wb of the intermediate part 15b. This section is referred to as a wide section (corresponding to a "first section") 221 (see FIG. 4B). A rear end of the wide section 221 corresponds to a boundary between a region with a wider width and a region with a width the same as the width Wb of the intermediate part 15b. A front end of the wide section 221 is the front end of each of the wall conductors 153 and 154. A section length of the wide section 221 is represented by a length La (see FIG. 4B). In Embodiment 1, a dimension of a rear-side wide section (corresponding to the "first section") 222 of the waveguide 15 may be the same as and/or similar to that of the front-side wide section 221.

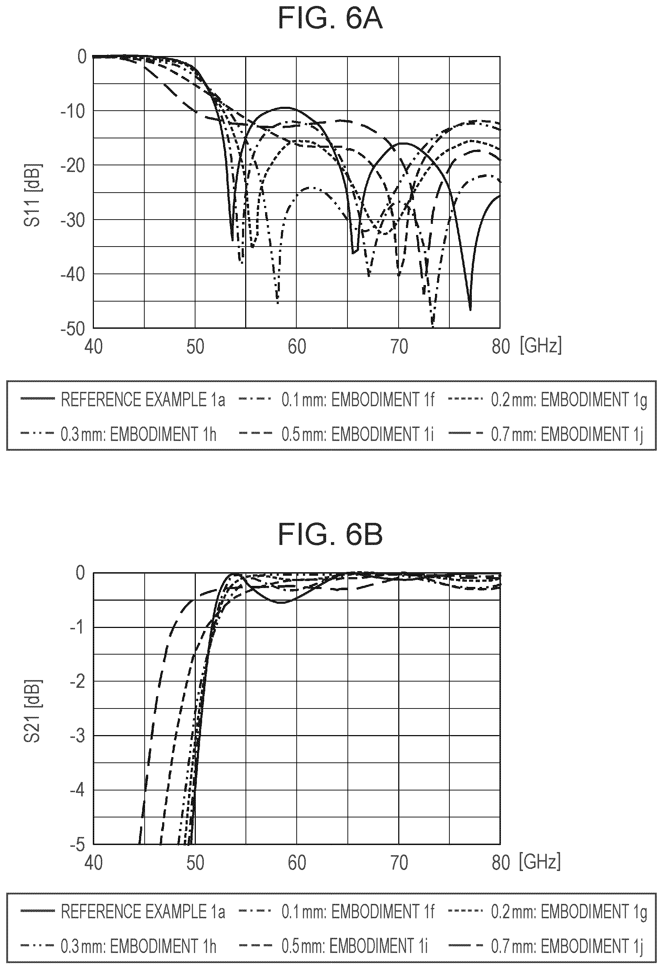

The waveguide 15 may include the wide sections 221 and 222 as described above. As shown in simulation results described later (see FIGs. 6A and 6B), with this configuration, favorable characteristics are achievable.

The length La of each of the wide sections 221 and 222 of the waveguide 15 may be equal to or less than 1/3 (= 0.5 mm) the effective wavelength λ of a transmission signal. The effective wavelength λ of a transmission signal means an effective wavelength at a center frequency in a frequency band of a transmission signal. As shown in the simulation results described later (see FIGs. 6A and 6B), with this configuration, more favorable characteristics are achievable.

As illustrated in FIGs. 4A and 4B, the widths Wa and Wd of the wide sections 221 and 222 may be constant from tip ends to rear ends of the wide sections 221 and 222. The width Wa of the wide section 221 at one side may be the same as the width Wd of the wide section 222 at the other side. The width Wb of the section other than the wide sections 221 and 222 may be constant from a front end to the other end of this section.

FIGs. 5A and 5B are graphs showing reflection characteristics and transmission characteristics, respectively, of Embodiments 1a to 1e and Reference Example 1a with different ratios "Wa/Wb". The wiring board 10 of Embodiment 1 includes a plurality of configurations in which only ratios "Wa/Wb" and "Wd/Wb" vary, and these configurations are referred to as Embodiments 1a to 1e. The ratios "Wa/Wb" of Embodiments 1a to 1e are "× 1.1", "× 1.2", "× 1.3", "× 1.4", and "× 1.6", respectively. In Embodiments 1a to 1e, the length La of the wide section 221 is common at 0.3 mm, the width Wa is uniform across the wide section 221, and the width Wb is the reference width. In Embodiments 1a to 1e, the length La of the wide section 222 at the other side is common at 0.3 mm, and the width Wd is uniform across the wide section 222. In each of Embodiments 1a to 1e, the width Wa of the wide section 221 at one side is the same as the width Wd of the wide section 222 at the other side.

FIGs. 5A and 5B illustrate that, in Embodiments 1a to 1e, favorable characteristics are achievable in most part of a frequency band of a transmission signal. Particularly, the configuration with the ratio "Wa/Wb" of 1.4 or less is shown to achieve more favorable characteristics than those of Reference Example 1a. Further, the configuration with the ratio "Wa/Wb" of 1.4 or less is shown to have improved characteristics of a lower-limit frequency of a transmission signal. In the same and/or similar manner, particularly, the configuration with the ratio "Wd/Wb" of 1.4 or less is shown to achieve more favorable characteristics than those of Reference Example 1a. Further, the configuration with the ratio "Wd/Wb" of 1.4 or less is shown to have improved characteristics of a lower-limit frequency of a transmission signal.

FIGs. 6A and 6B are graphs showing reflection characteristics and transmission characteristics, respectively, of Embodiments 1f to 1j and Reference Example 1a with different wide-section lengths. The wiring board 10 of Embodiment 1 includes a plurality of configurations in which only the length La of the wide section 221 varies, and these configurations are referred to as Embodiments 1f to 1j. The lengths La of the wide section 221 of Embodiments 1f to 1j are "0.1 mm" (= 0.07 λ), "0.2 mm" (= 0.14 λ), "0.3 mm" (= 0.2 λ), "0.5 mm" (= 0.33 λ), and "0.7 mm" (= 0.5 λ), respectively. In Embodiments 1f to 1j, the ratio Wa/Wb of the width is "× 1.2" and common between Embodiments 1f to 1j. In each of the Embodiments 1f to 1j, the length La and the width Wa of the wide section 221 at one side are the same as the length La and the width Wd of the wide section 222 at the other side, respectively. The "λ" is an effective wavelength at a center frequency of a transmission signal.

FIGs. 6A and 6B illustrate that, Embodiments 1f to 1j can achieve more favorable characteristics than Reference Example 1a. Particularly, the configuration with the length La of 0.5 mm or less, that is, equal to or less than 1/3 the effective wavelength λ, is shown to achieve more favorable characteristics.

### (Embodiment 2)

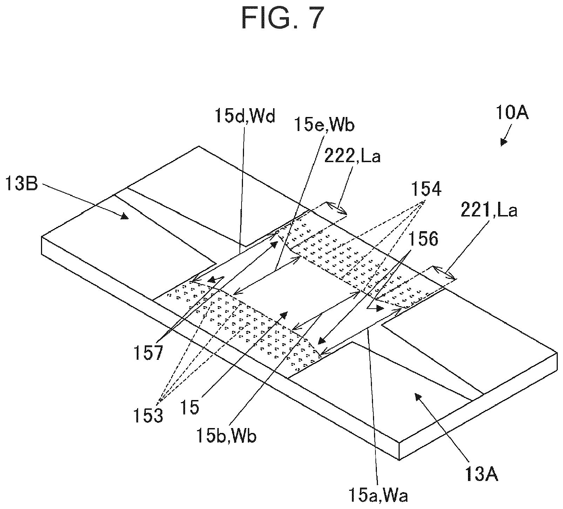

FIG. 7 is a perspective view illustrating a wiring board according to Embodiment 2 of the present disclosure. A wiring board 10A of Embodiment 2 may be the same as and/or similar to that of Embodiment 1 except for that the wide section 221 of the waveguide 15 includes a different configuration.

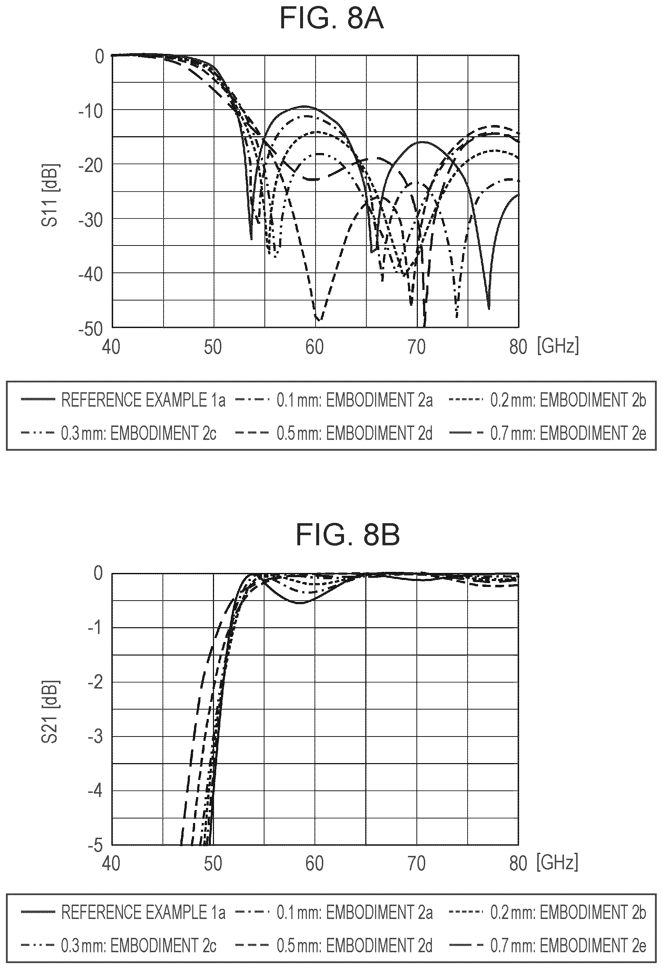

In Embodiment 2, the wide sections 221 and 222 of the waveguide 15 may include gradually widening parts 156 and 157 with a gradually increasing width toward the end parts of the waveguide 15, respectively. As shown in simulation results described later (FIGs. 8A and 8B), with this configuration, favorable characteristics are achievable. The gradually widening part 156 may be located across the entire wide section 221. The gradually widening part 157 may be located across the entire wide section 222.

FIGs. 8A and 8B are graphs showing reflection characteristics and transmission characteristics, respectively, of Embodiments 2a to 2e and Reference Example 1a with different wide-section lengths. The wiring board 10A of Embodiment 2 includes a plurality of configurations in which only the length La of each of the wide sections 221 and 222 varies, and these configurations are referred to as Embodiments 2a to 2e. The lengths La of each of the wide sections 221 and 222 of Embodiments 2a to 2e are "0.1 mm" (= 0.07 λ), "0.2 mm" (= 0.14 λ), "0.3 mm" (= 0.2 λ), "0.5 mm" (= 0.33 λ), and "0.7 mm" (= 0.5 λ), respectively. In each embodiment, the gradually widening parts 156 and 157 are located across the entire wide sections 221 and 222, respectively. In Embodiments 2a to 2e, the ratios "Wa/Wb" and "Wd/Wb" of the width are both 1.2 and common between Embodiments 2a to 2e. The width Wa of the front-end part 15a corresponds to a maximum width of the wide section 221. The width Wd of the rear-end part 15d corresponds to a maximum width of the wide section 222. The "λ" is an effective wavelength at a center frequency of a transmission signal.

FIGs. 8A and 8B illustrate that, in Embodiments 2a to 2e, characteristics more favorable than Reference Example 1a are achievable. As can be seen in comparison between the characteristics in FIGs. 8A and 8B and the characteristics in FIGs. 6A and 6B, the wide sections 221 and 222 achieve more favorable characteristics when including the gradually widening parts 156 and 157, respectively.

### (Embodiments 3a to 3c)

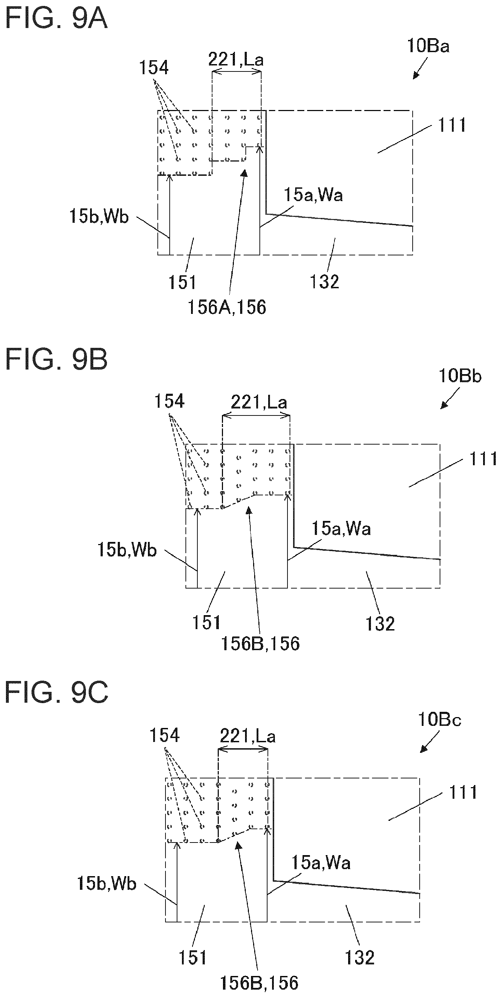

FIGs. 9A to 9C are plan views illustrating parts of wiring boards of Embodiments 3a, 3b, and 3c of the present disclosure, respectively. FIGs. 9A to 9C are each plan view around the wall conductor 154 at the coupling part between the first signal line 13A and the waveguide 15. Wiring boards 10Ba to 10Bc of Embodiments 3a to 3c may be the same as and/or similar to that of Embodiment 2 except for that the wiring boards 10Ba to 10Bc each includes a pattern of the gradually widening part 156 at the front-end portion and a pattern of the gradually widening part 157 at the rear-end portion that are different from those of Embodiment 2. Although illustration of the pattern of the gradually widening part 157 at the rear-end portion is omitted, the pattern of the gradually widening part 157 at the rear-end portion may be the same as and/or similar to (for example, reflectional symmetry to) the pattern of the gradually widening part 156 at a tip-end portion.

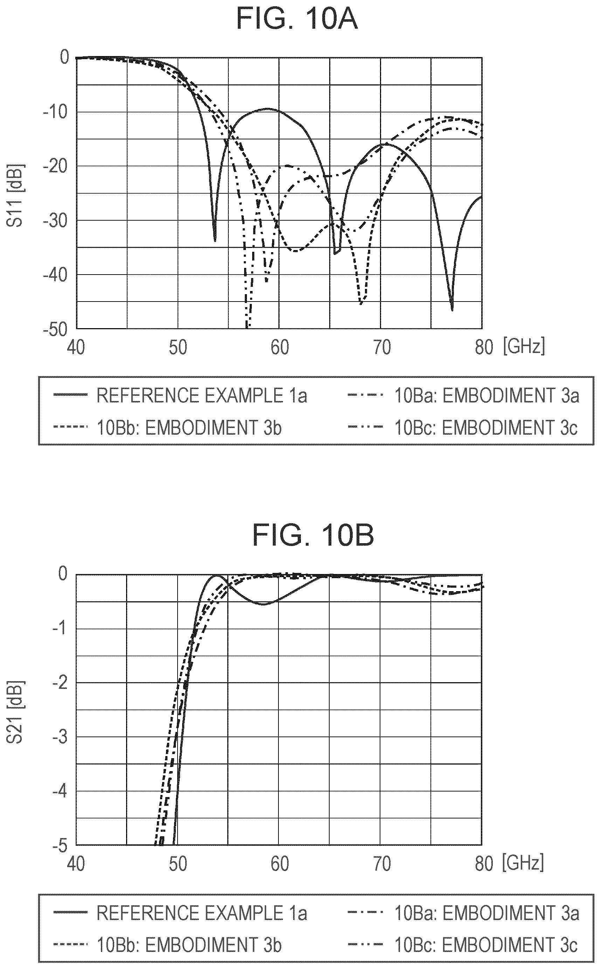

In the way as Embodiment 3a in FIG. 9A, the gradually widening part 156 may include a stepped part 156A having a width increasing in a stepped manner. In the way as Embodiments 3b and 3c in FIGs. 9B and 9C, the gradually widening part 156 may include an inclined part 156B having a width increasing in a continuous manner. As shown in simulation results described later (see FIGs. 10A and 10B), also in this configuration, the gradually widening part 156 can achieve favorable characteristics.

When the wall conductor 153 includes multiple conductors arranged with a gap therebetween, whether the wall conductor 153 has a width increasing in a stepped manner or a width increasing in a continuous manner may be identified as described below. That is, a surface conductor with a minimum area is assumed to fill a space between a pair of wall conductors 153. Such a pair of wall conductors 153 are adjacent to one another at a distance from 1/4 or less to 1/8 or less of an effective wavelength of a transmission signal (that is, an effective wavelength at a center frequency). In such a configuration of filling with the surface conductor, whether the width increases in a stepped manner or in a continuous manner is identifiable.

FIGs. 10A and 10B are graphs showing reflection characteristics and transmission characteristics, respectively, of the wiring boards 10Ba to 10Bc of Embodiments 3a to 3c and the wiring board of Reference Example 1a. FIGs. 10A and 10B illustrate that favorable characteristics are achievable when the gradually widening part 156 widens either in a stepped manner or in a continuous manner.

In Embodiments 3a to 3c, the ratios "Wa/Wb" of the width of the front-end part 15a to the width of the intermediate part 15b are "× 1.4", "× 1.2", and "× 1.2", respectively, thus being partially different, and the lengths La of the wide section 221 are "0.3 mm", "0.4 mm", and "0.3 mm", respectively, thus being partially different. In the same and/or similar manner as/to the ratio "Wa/Wb" and the length La of the wide section 221 mentioned above, the ratio "Wd/Wb" of the width of the rear-end part 15d to the width of the intermediate part 15e and the length La of the wide section 222 have difference. Such difference causes comparatively largely difference in the characteristics of Embodiments 3a to 3c in FIGs. 10A and 10B.

### (Embodiments 4a and 4b)

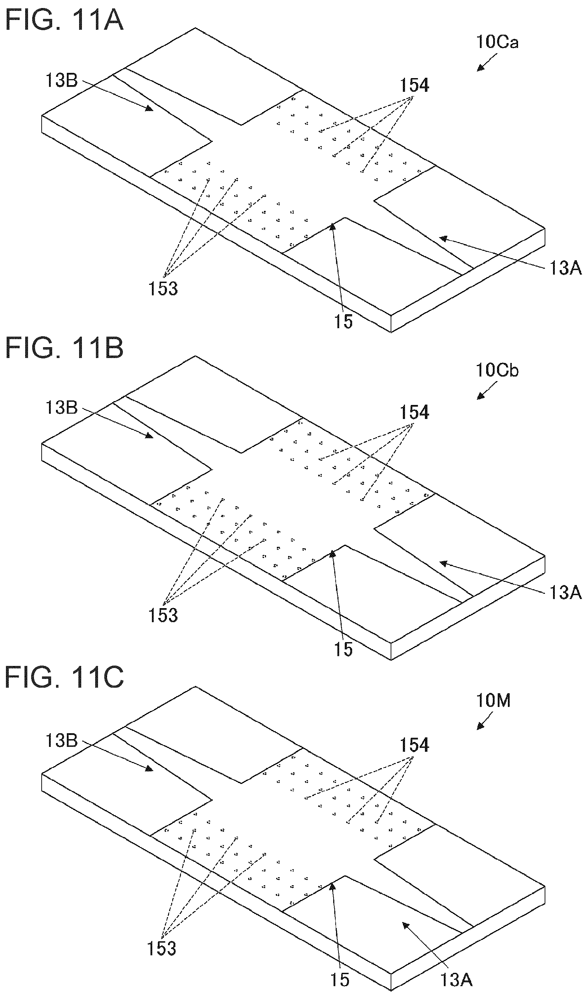

FIGs. 11A to 11C are perspective views illustrating Embodiments 4a and 4b and Reference Example 2 of the present disclosure, respectively. A wiring board 10Ca of Embodiment 4a may be the same as and/or similar to that of Embodiment 1 except for that a pitch of the plurality of wall conductors (for example, via conductors) 153 and 154 is wider at approximately 0.2 mm. A wiring board 10Cb of Embodiment 4b may be the same as and/or similar to that of Embodiment 2 except for that the pitch of the plurality of wall conductors (for example, via conductors) 153 and 154 is wider at approximately 0.2 mm.

The pitch describe above means a center distance between the wall conductors 153 and between the wall conductors 154. The wall conductors 153 and 154 are via conductors. The pitch of the wall conductors 153 and 154 in Embodiments 1a to 1j, 2a to 2e, and 3a to 3c is approximately 0.1 mm.

As illustrated in FIGs. 11A and 11B, the pitch of the wall conductors 153 and 154 may be λ/4 (for example, 0.38 mm) or less. The "λ" is an effective wavelength at a center frequency of a transmission signal. With this configuration, a gap between the wall conductors 153 and a gap between the wall conductors 154 can cause less leakage of a transmission signal, resulting in achieving favorable characteristics. The wall conductors 153 and 154 are multiple via conductors.

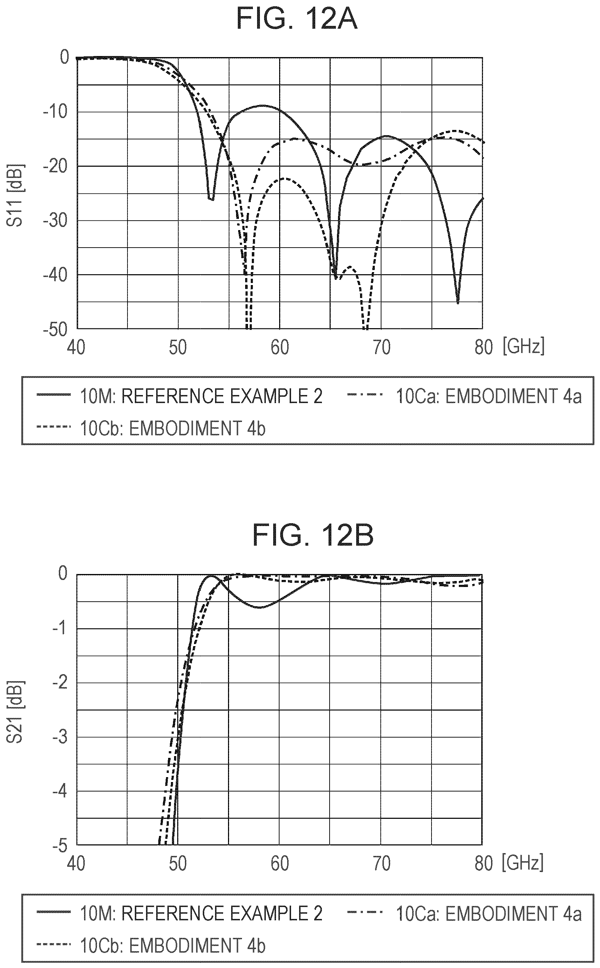

As illustrated in FIGs. 11A and 11B, the pitch of the wall conductors 153 and 154 may be a large value, such as λ/8 or more and λ/4 or less. As shown in simulation results described later (see FIGs. 12A and 12B), favorable characteristics are achievable also in this configuration. In addition, adoption of a large pitch can increase a diameter of each of the wall conductors (for example, via conductors) 153 and 154, and the wall conductors 153 and 154 have improved manufacturability.

FIGs. 12A and 12B are graphs showing reflection characteristics and transmission characteristics, respectively, of the wiring boards of Embodiments 4a and 4b and a wiring board of Reference Example 2. As illustrated in FIG. 11C, a wiring board 10M of Reference Example 2 may be the same as and/or similar to the wiring board 10L of Reference Example 1a except for that the pitch of the plurality of wall conductors 153 and 154 is approximately 0.2 mm. FIGs. 12A and 12B illustrate that even when the wall conductors 153 and 154 include a large pitch, the waveguide 15 including the end part with a wide width causes improved characteristics.

### (Embodiment 5)

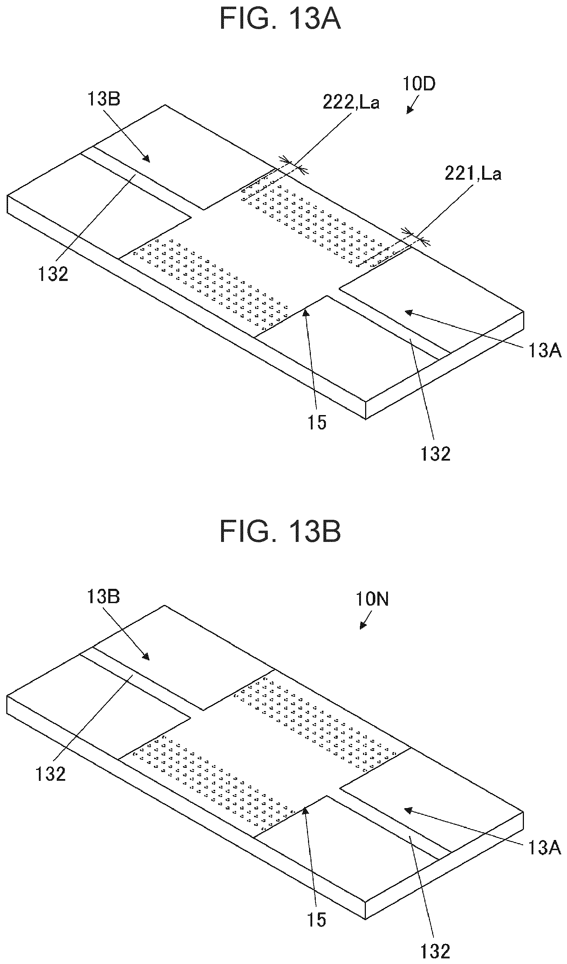

FIG. 13A is a perspective view illustrating a wiring board of Embodiment 5 of the present disclosure. FIG. 13B is a perspective view illustrating a wiring board of Reference Example 3. A wiring board 10D of Embodiment 5 may be the same as and/or similar to that of Embodiment 1 except for that a shape of the belt-like conductor 132 of each of the first signal line 13A and the second signal line 13B is different. A wiring board 10N of Reference Example 3 is the same as and/or similar to that of Reference Example 1a except for that a width of the belt-like conductor 132 of each of the first signal line 13A and the second signal line 13B is uniform.

As illustrated in FIG. 13A, the belt-like conductor 132 of the first signal line 13A may have a uniform width from one end to the other end. The same and/or similar holds for the belt-like conductor 132 of the second signal line 13B. Also in this configuration, the waveguide 15 including the end part with a wide width causes favorable characteristics.

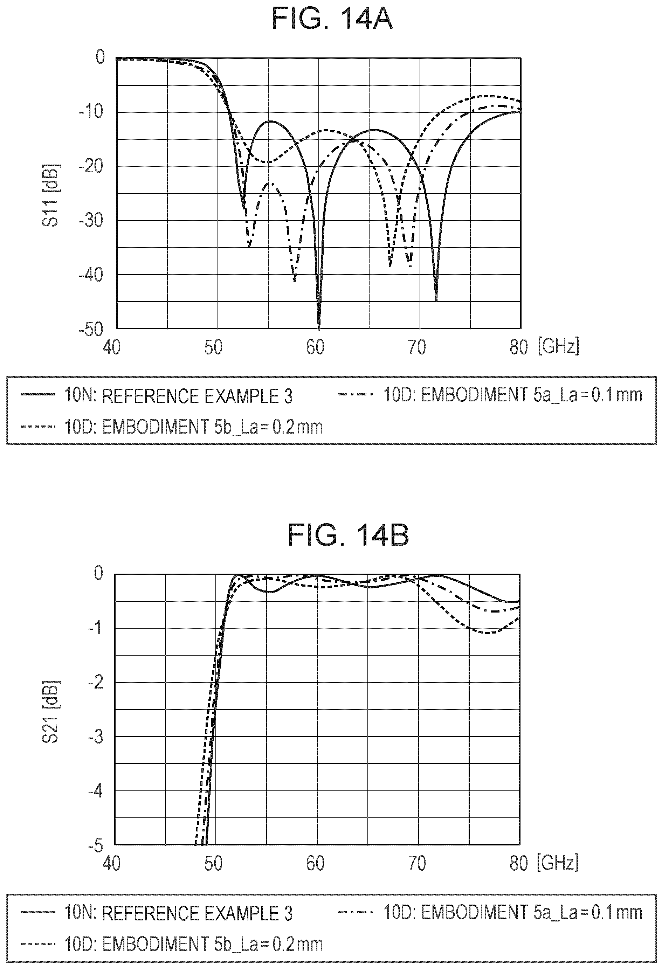

FIGs. 14A and 14B are graphs showing reflection characteristics and transmission characteristics, respectively, of wiring boards of Embodiments 5a and 5b and the wiring board of Reference Example 3. The wiring board 10D of Embodiment 5 includes a plurality of configurations in which only the length La of the wide section 221 varies, and these configurations are referred to as Embodiments 5a and 5b. The lengths La of the wide section 221 in Embodiments 5a and 5b are "0.1 mm" (= 0.07 λ) and "0.2 mm" (= 0.14 λ), respectively. In Embodiments 5a and 5b, the ratio Wa/Wb of the width at the front-end portion is "× 1.2" and common between Embodiments 5a and 5b, and the width of the waveguide 15 is uniform across the wide section 221. In the same and/or similar manner, in Embodiments 5a and 5b, the ratio Wd/Wb of the width at the rear-end portion is "× 1.2" and common between Embodiments 5a and 5b, and the width of the waveguide 15 is uniform across the wide section 222.

The "λ" is an effective wavelength at a center frequency of a transmission signal.

FIGs. 14A and 14B illustrate that even when one or both of the first signal line 13A and the second signal line 13B include the belt-like conductor 132 having the same width, the waveguide 15 including the end part with a wide width causes improved characteristics.

As shown in comparison between the characteristics at "0.1 mm" and "0.2 mm" in FIGs. 14A and 14B and the characteristics at "0.1 mm" and "0.2 mm" in FIGs. 6A and 6B, more favorable characteristics are achievable when the belt-like conductor 132 of each of the first signal line 13A and the second signal line 13B includes a portion that widens as approaching the waveguide 15.

### (Embodiment 6)

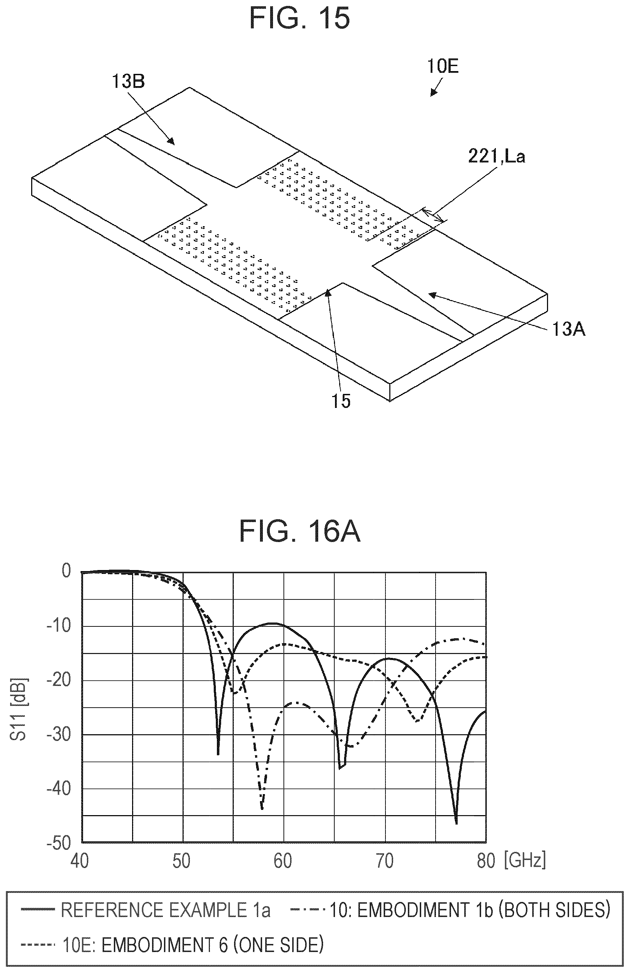

FIG. 15 is a perspective view illustrating a wiring board of Embodiment 6 of the present disclosure. A wiring board 10E of Embodiment 6 may be the same as and/or similar to that of Embodiment 1 except for that the wide section 221 is present only at one side in the front-rear direction of the waveguide 15. Also in this configuration, the waveguide 15 including at the front part thereof the wide section 221 causes favorable characteristics.

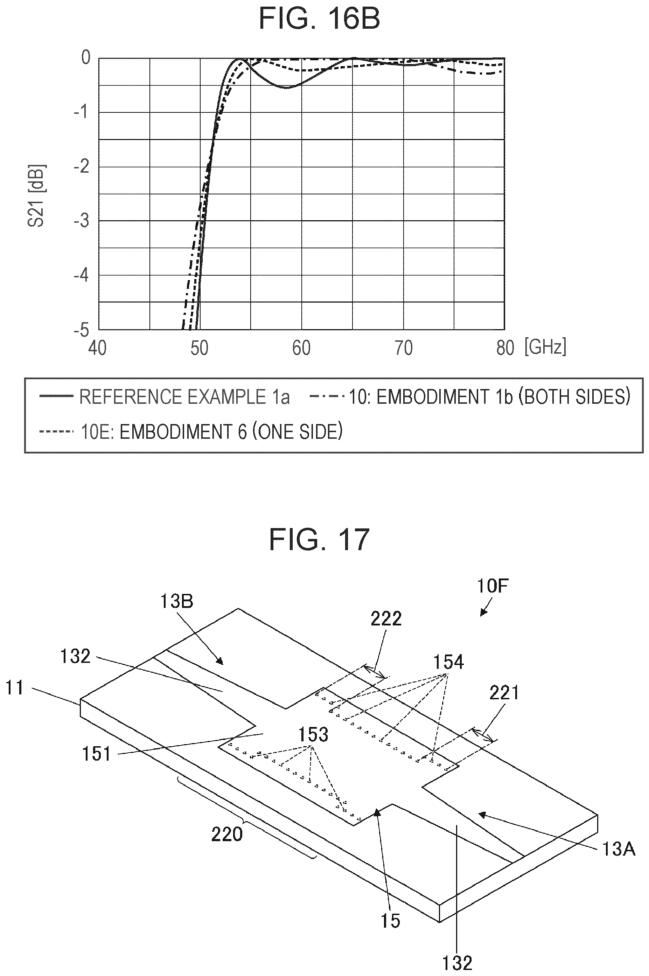

FIGs. 16A and 16B are graphs showing reflection characteristics and transmission characteristics, respectively, of the wiring boards of Embodiments 6 and 1b and the wiring board of Reference Example 1a. In Embodiment 6, the wide section 221 is present only at one side in the front-rear direction, in Embodiment 1b, the wide sections 221 and 222 are present at the respective sides in the front-rear direction, and in Reference Example 1a, the waveguide 15 has a uniform width.

FIGs. 16A and 16B illustrate that characteristics improve even when the waveguide 15 includes the end part with a wide width only at one side of the waveguide 15 in the front-rear direction. In addition, FIGs. 16A and 16B illustrate that the characteristics further improve when the configuration with a wide width is adopted at both sides of the waveguide 15 in the front-rear direction.

### (Other Embodiments)

Although the wiring boards 10 to 10E of Embodiments 1 to 6 are described above, the wiring board of the present disclosure is not limited to those with the configurations of Embodiments 1 to 6. For example, Embodiments 1 to 6 describe, as each of the wall conductors 153 and 154 of the waveguide 15, a pseudo conductor wall including multiple via conductors arranged with a gap therebetween. However, each of the wall conductors 153 and 154 may adopt, instead of a via conductor in a circular shape in plan view, a via conductor in an elongated hole shape in plan view, or adopt a conductor in a film shape, a wall-panel shape, or a block shape that partitions a transmission line in a lateral direction.

FIG. 17 is a perspective view illustrating a wiring board 10F of Embodiment 7 of the present disclosure. Embodiments 1 to 6 describe the configuration in which the wall conductor 153 at the left includes a plurality of rows of via conductors. However, as illustrated in the wiring board 10F in FIG. 17, the wall conductor 153 at the left may include only one row of via conductors arranged at the signal transmission line side. The same and/or similar holds for the wall conductor 154 at the right. The one example means a row that continues in the front-rear direction. Other than those described above, instead of the film-like conductor 151 being located on the entire second section 220, as illustrated in FIG. 17, the film-like conductor 151 may be located in a range covering the upper side the signal transmission line of the waveguide 15. The same and/or similar holds for the film-like conductor 152 at the lower side. As illustrated in FIG. 17, the base body 11 may be exposed at a side surface of the wiring board 10F.

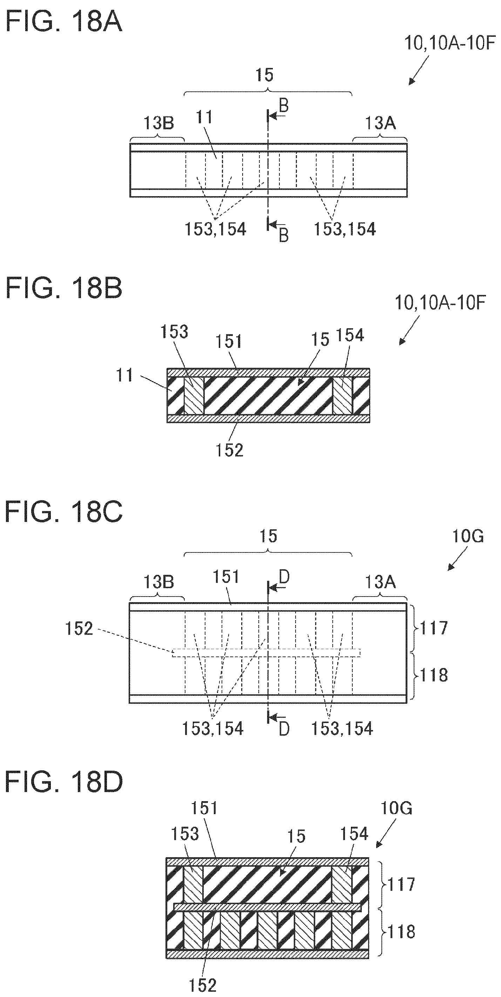

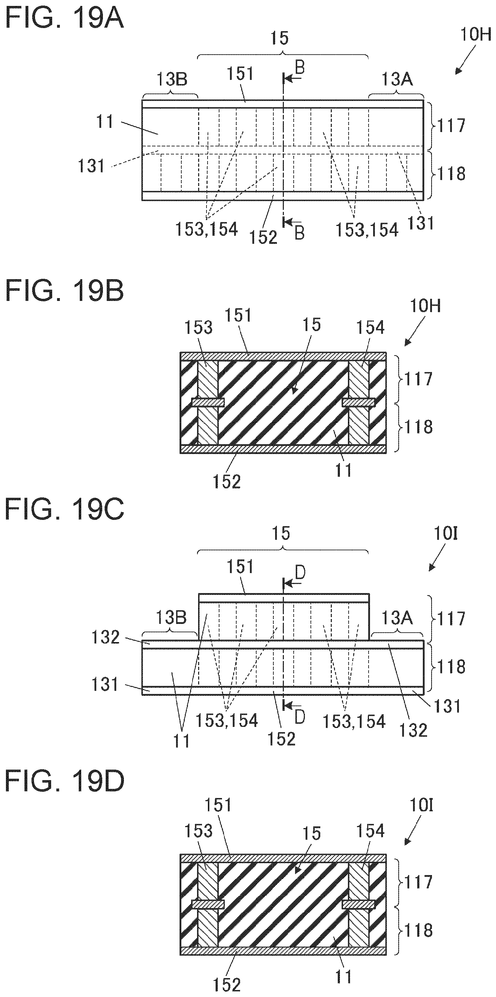

FIGs. 18A to 18D and 19A to 19D are schematic views for explaining arrangement variations in the up-down direction of the first signal line 13A, the waveguide 15, and the second signal line 13B. FIG. 18A is a side view of the wiring boards 10 and 10A to 10F of Embodiments 1 to 7. FIG. 18B is a sectional view taken along line B-B in FIG. 18A. FIG. 18C is a side view of a wiring board 10G of Embodiment 8 of the present disclosure. FIG. 18D is a sectional view taken along line D-D in FIG. 18C. FIG. 19A is a side view of a wiring board 10H of Embodiment 9 of the present disclosure. FIG. 19B is a sectional view taken along line B-B in FIG. 19A. FIG. 19C is a side view of a wiring board 10I of Embodiment 10 of the present disclosure. FIG. 19D is a sectional view taken along line D-D in FIG. 19C.

As illustrated in FIGs. 18A and 18B, Embodiments 1 to 7 describe the example in which the first signal line 13A, the waveguide 15, and the second signal line 13B have the same thickness, and the first signal line 13A, the waveguide 15, and the second signal line 13B are located in the same layer of the base body 11. However, any of the first signal line 13A, the waveguide 15, or the second signal line 13B may have a thickness different from the others. The first signal line 13A and the waveguide 15 may be coupled to one another at different positions in the up-down direction. In the same and/or similar manner, the waveguide 15 and the second signal line 13B may be coupled to one another at different positions in the up-down direction.

The wiring board 10G of Embodiment 8 in FIGs. 18C and 18D is an example in which the first signal line 13A and the second signal line 13B are located across a first layer 117 and a second layer 118 of the base body 11, and the waveguide 15 is located in the second layer 118 of the base body 11.

The wiring board 10H of Embodiment 9 in FIGs. 19A and 19B is an example in which the first signal line 13A and the second signal line 13B are located in the second layer 118 of the base body 11, and the waveguide 15 is located across the first layer 117 and the second layer 118 of the base body 11.

The wiring board 10I of Embodiment 10 in FIGs. 19C and 19D is an example in which a thickness of the base body 11 is different between the section of the first signal line 13A and the second signal line 13B and the section of the waveguide 15. The first signal line 13A and the second signal line 13B may be located in the second layer 118, and the waveguide 15 may be located across the first layer 117 and the second layer 118.

Embodiments 1 to 10 describe the configuration in which the first signal line 13A and the second signal line 13B sandwich the waveguide 15 therebetween. However, the configuration is not limited to this as long as a wiring board includes at least one signal line and one waveguide coupled to one another.

### (Electronic Component Storage Package and Electronic Device)

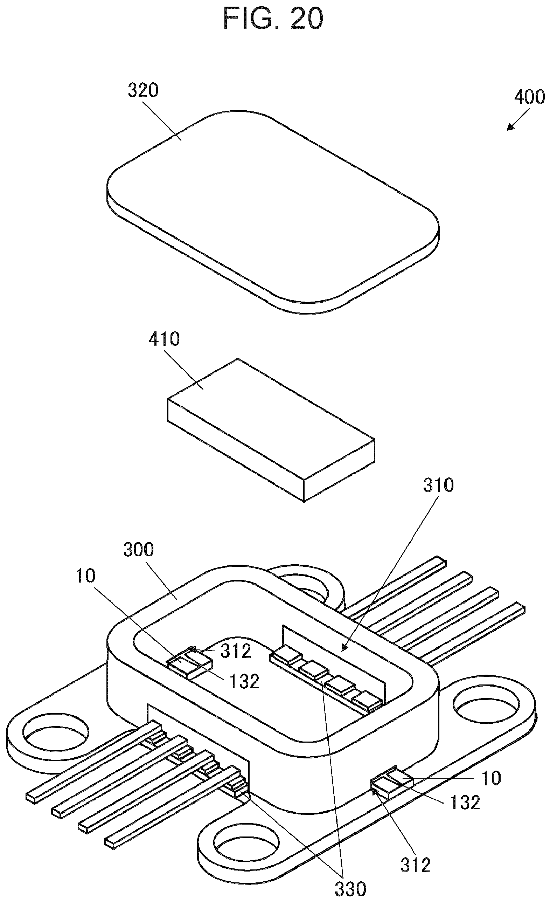

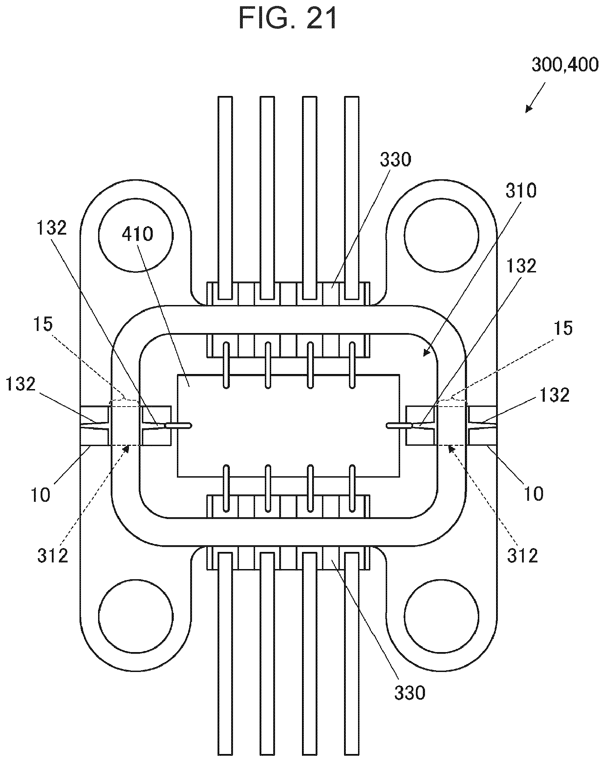

FIG. 20 is an exploded perspective view illustrating an electronic component storage package and an electronic device according to an embodiment of the present disclosure. FIG. 21 is a plan view illustrating an electronic component storage package and an electronic device according to an embodiment of the present disclosure.

An electronic component storage package 300 of this embodiment includes the wiring board 10 of Embodiment 1. Instead of the wiring board 10, any of the wiring boards 10A to 10I of the other embodiments is applicable. The electronic component storage package 300 may include a recess part 310 that accommodates an electronic component 410, and a lid body 320 that closes an opening of the recess part 310. The wiring board 10 may be located at a through-hole 312 positioned at a part of a side wall of the recess part 310. The through-hole 312 communicates from inside to outside of the recess part 310. One end part of a signal transmission line of the wiring board 10 may be located inside of the recess part 310, and the other end part may be located outside of the recess part 310. The side wall of the recess part 310 is a conductor and may contact the film-like conductor 151 of the wiring board 10 to be grounded. The wiring board 10 may include the film-like conductors 131, 151, 152, 121, and 122 joined to an inner surface of the through-hole 312 with a bonding material interposed therebetween, thus closing the through-hole 312. With this configuration, the through-hole 312 can secure high airtightness.

The electronic component storage package 300 may include a plurality of wiring boards 10. The electronic component storage package 300 may include a substrate 330 that communicates another signal, such as power supply voltage, between the outside and the inside of the recess part 310.

An electronic device 400 of this embodiment includes the electronic component storage package 300 and the electronic component 410 stored in the electronic component storage package 300. The electronic component 410 may perform one or both of input and output of a radio-frequency signal. A terminal of the electronic component 410 for a radio-frequency signal may be coupled to the belt-like conductor 132 of the second signal line 13B of the wiring board 10 with a connection conductor interposed therebetween.

Note that the electronic component storage package of the present disclosure is not limited to the example described above. For example, a wiring board may be disposed inside a recess part that stores an electronic component and transmit a radio-frequency signal inside the recess part.

Below, an embodiment of the present disclosure is described. In an embodiment, (1) a wiring board includes: a base body; a signal line located at the base body; and a waveguide of a waveguide-type located at the base body, wherein the signal line includes a first end part that is one end of the signal line in a signal transmission direction, the waveguide includes: a second end part that is one end of the waveguide in the signal transmission direction; a center part in the signal transmission direction; and an intermediate part on a side of the second end part closer to the center part, the first end part and the second end part are coupled to one another, and a width Wa of the waveguide at the second end part is wider than a width Wb of the waveguide at the intermediate part.
(2) In the wiring board of (1), a ratio Wa/Wb of the width Wa of the waveguide at the second end part to the width Wb of the waveguide at the intermediate part is 1 < Wa/Wb ≤ 1.4.
(3) In the wiring board of (1) or (2), the waveguide is wider across a first section extending from the second end part in the signal transmission direction than the intermediate part, and a length of the first section is equal to or less than 1/3 an effective wavelength of a transmission signal.
(4) In the wiring board of (1) or (2), the waveguide includes a gradually widening part in which a width of the waveguide gradually increases toward the second end part.
(5) In the wiring board of (4), the gradually widening part includes a stepped part in which the width of the waveguide increases in a stepped manner.
(6) In the wiring board of (4), the gradually widening part includes an inclined part in which the width of the waveguide increases in a continuous manner.
(7) In the wiring board of any one of (1) to (6), the base body includes a plurality of via conductors located at an edge of the waveguide, and a pitch of the plurality of via conductors is equal to or less than 1/4 an effective wavelength of a transmission signal.
(8) In the wiring board of any one of (1) to (7), a width of the signal line gradually increases toward the first end part.
(9) In an embodiment, an electronic component storage package includes the wiring board of any one of (1) to (8).
(10) In an embodiment, an electronic device includes: the electronic component storage package of (9); and an electronic component stored in the electronic component storage package.

### INDUSTRIAL APPLICABILITY

The present disclosure is applicable to a wiring board, an electronic component storage package, and an electronic device.

### REFERENCE SIGNS

10, 10A, 10Ba-10Bc, 10Ca, 10Cb, 10D-10I wiring board
11 base body
111 first main surface
112 second main surface
13 signal line
13A first signal line
13Aa rear-end part (first end part)
13B second signal line
13Ba front-end part (first end part)
131 film-like conductor
132 belt-like conductor
15 waveguide
15a front-end part (second end part)
15b, 15e intermediate part
15c center part
15d rear-end part (second end part)
151, 152 film-like conductor
153, 154 wall conductor
156, 157 gradually widening part
156A stepped part
156B inclined part
221, 222 wide section
300 electronic component storage package
310 recess part
312 through-hole
400 electronic device
410 electronic component
La wide-section length
W waveguide width
Wa front-end part width
Wb intermediate part width
Wd rear-end part width
Wa/Wb ratio
Wd/Wb ratio

## Claims

1. A wiring board comprising:
a base body;
a signal line located at the base body; and
a waveguide of a waveguide-type located at the base body, wherein
the signal line comprises a first end part that is one end of the signal line in a signal transmission direction,
the waveguide comprises:
a second end part that is one end of the waveguide in the signal transmission direction;
a center part in the signal transmission direction; and
an intermediate part on a side of the second end part closer to the center part,
the first end part and the second end part are coupled to one another, and
a width Wa of the waveguide at the second end part is wider than a width Wb of the waveguide at the intermediate part.

2. The wiring board according to claim 1, wherein a ratio Wa/Wb of the width Wa to the width Wb is 1 < Wa/Wb ≤ 1.4.

3. The wiring board according to claim 1, wherein the waveguide is wider across a first section extending from the second end part in the signal transmission direction than the intermediate part, and
a length of the first section is equal to or less than 1/3 an effective wavelength of a transmission signal.

4. The wiring board according to claim 1, wherein the waveguide comprises a gradually widening part in which a width of the waveguide gradually increases toward the second end part.

5. The wiring board according to claim 4, wherein the gradually widening part comprises a stepped part in which the width of the waveguide increases in a stepped manner.

6. The wiring board according to claim 4, wherein the gradually widening part comprises an inclined part in which the width of the waveguide increases in a continuous manner.

7. The wiring board according to claim 1, wherein the base body comprises a plurality of via conductors located at an edge of the waveguide, and
a pitch of the plurality of via conductors is equal to or less than 1/4 an effective wavelength of a transmission signal.

8. The wiring board according to claim 1, wherein a width of the signal line gradually increases toward the first end part.

9. An electronic component storage package comprising the wiring board according to claim 1.

10. An electronic device comprising:
the electronic component storage package according to claim 9; and
an electronic component stored in the electronic component storage package.
